# EUROPEAN PATENT SPECIFICATION

(11) **EP 3 785 037 B1**
(45) Date of publication and mention of the grant of the patent: **09.08.2023**
(21) Application number: 19721053.7
(22) Date of filing: 21.03.2019
(51) Int. Cl.: G01R 27/02

(54) **A STATION AND METHOD FOR CHECKING THE ELECTRIC CIRCUIT OF ELECTRONIC CIGARETTES**
STATION UND VERFAHREN ZUR PRÜFUNG DER ELEKTRISCHEN SCHALTUNG VON ELEKTRONISCHEN ZIGARETTEN
STATION ET PROCÉDÉ DE VÉRIFICATION DU CIRCUIT ÉLECTRIQUE DE CIGARETTES ÉLECTRONIQUES

(30) Priority: 24.04.2018 IT 201800004816
(43) Date of publication of application: 03.03.2021
(73) Proprietor: G.D S.p.A., 40133 Bologna (BO) (IT)
(72) Inventor: TALLERICO, Andrea, 88100 Catanzaro (IT); CUCCHI, Manuele, 40069 Zola Predosa (Bologna) (IT); RENCO, Francesco, 40013 Castel Maggiore (Bologna) (IT); MORETTI, Carlo, 40132 Bologna (IT); TESTONI, Luca, 40013 Castel Maggiore (Bologna) (IT); LANZARINI, Luca, 40053 Valsamoggia (Bologna) (IT); FEDERICI, Luca, Deceased (IT)
(74) Representative: Marchitelli, Mauro
(86) International application number: PCT/IB2019/052302
(87) International publication number: WO 2019/207374

(56) References cited:
- WO-A1-2016/119171
- WO-A1-2016/127327
- CN-U- 203 941 232

## Description

The present invention falls within the technical sector of electronic cigarettes. In particular, the invention relates to a station and a method for checking the electric circuit of electronic cigarettes.

As known, in electronic cigarettes there is a cartridge through which a liquid is vaporized to generate aerosols by feeding electrical energy. The electric circuit is present in the cartridge, which comprises a heating element that causes vaporization of the liquid, and terminals made of conductive material, which are connected to the heating element. The electronic cigarette also comprises a power supply battery which is connected to the terminals, allowing the heating element to be heated.

The correct functioning of the electric circuit is essential to guarantee the quality of the finished product.

To date, electronic cigarettes are assembled in dedicated automatic machines, in which the various parts are fed into consecutive stations. The battery is usually coupled to the terminals at the end of the assembly. Therefore, it is necessary to check the electric circuit before assembly is completed, to avoid waste of time and material. Examples of known devices for measuring resistance of electronic cigarettes can be seen in WO 2016/119171 A1, WO 2016/127327 A1 and CN 203 941 232 U.

The object of the present invention is to propose a solution that allows the electric circuit of electronic cigarettes to be checked. This object is achieved by proposing a station and a method for checking the electric circuit of electronic cigarettes according to the attached claims.

Advantageously, the invention allows automatic checking of the electronic circuit of electronic cigarettes. Therefore, it is possible to guarantee the correct functioning (or rather, to guarantee the quality of the finished product, that is, of the electronic cigarettes).

This and other advantages will be made clear in the following discussion, with the aid of the attached drawings, in which:
- Figure 1 is a partial perspective view of a check station of the electric circuit of cartridges of electronic cigarettes in accordance with the present invention;
- Figure 2 illustrates a cross-section of the check station of Figure 1;
- Figures 3 and 4 illustrate two enlarged cross-sectional views of the station of Figure 1, in two different operating configurations;
- Figure 5 is a view similar to that of Figure 4, according to a different embodiment of the invention.

With reference to the attached figures, numeral 1 indicates a check station of the electric circuit of cartridges of electronic cigarettes according to the present invention.

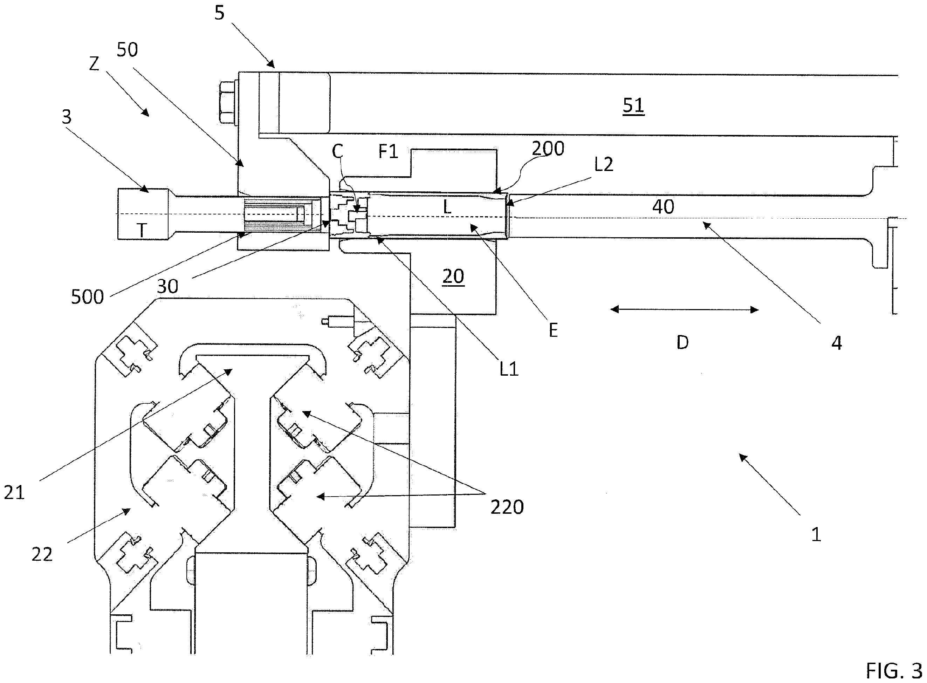

As already mentioned in the introductory part of the present discussion, the electric circuit of an electronic cigarette (in particular of a cartridge of an electronic cigarette) comprises a heating element which causes vaporization of the liquid, and terminals made of conductive material which are connected to the heating element. As known, in general an electronic cigarette, once completely assembled also comprises a power supply battery which is connected to the terminals, allowing heating of the heating element. Since the battery is only coupled to the terminals of the electric circuit at the end of the assembly operation, the check station described here allows the electric circuit to be checked before it is coupled with the battery. With reference to the attached figures, the electric circuit is indicated in Figures 3 to 5 with the reference C only as a representative, without being shown in detail.

In general, a cartridge E of an electronic cigarette has a longitudinal axis L with a first end L1 and a second end L2; the electric circuit C of each cartridge E is arranged at the first end L1 of the relative longitudinal axis L (see Figures 3-5). A cartridge E has, for example, a circular or quadrangular cross-section.

With reference to the attached figures, numeral 1 indicates a check station of the electric circuit C of cartridges E of electronic cigarettes according to the present invention.

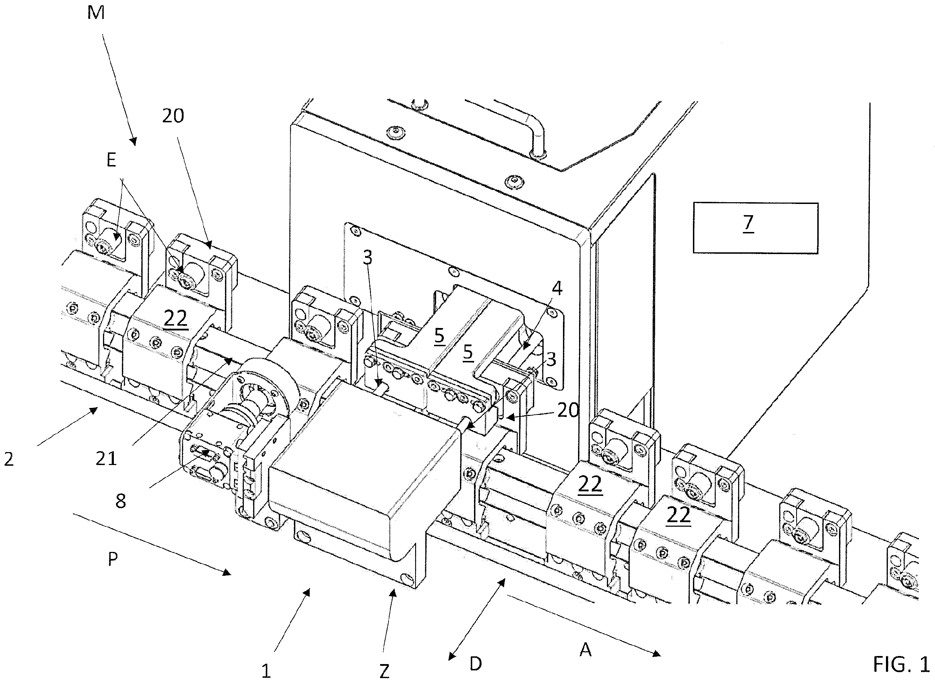

The check station 1 comprises: a conveying device 2 for conveying the cartridges E of electronic cigarettes along an advancement direction A (indicated only in Figure 1). In particular, the conveying device 2 comprises a plurality of holding elements 20, for retaining the cartridges E with a horizontal arrangement during their conveyance. In other words, the cartridges E are transported along the advancement path P with the relative longitudinal axis L lying on a plane parallel to the plane on which the advancement direction A lies (or rather, lying on a plane parallel to that on which the advancement path P lies).

The check station 1 also comprises a control assembly 3, 4, 5 arranged along the advancement path P at a checking area Z. The control assembly 3, 4, 5, in turn, comprises: at least one head 3 provided with at least one electrical contact 30 (preferably two); the head 3 has a longitudinal axis T and is arranged with a horizontal arrangement along the advancement path P (or rather, with the corresponding axis T that lies on a plane parallel to the plane on which the advancement direction A lies). The electrical contact 30 of the head 3 is only indicated in Figures 3-5.

In particular, the head 3 and the conveying device 2 are reciprocally arranged so that the electrical contact 30 of the head 3 and the electric circuit C of a cartridge E are facing and aligned with each other when a cartridge E is transported into the checking area Z.

The control assembly 3, 4, 5 further comprises movement means 4, 5 arranged for bringing the electric circuit C of the cartridge E (in particular the terminals) and the electrical contact 30 of the head 3 into contact with each other when the cartridge E is conveyed up to the checking area Z. The reciprocal movement of the head 3 and the cartridge E takes place in a movement direction D which lies on a plane parallel to the plane on which the advancement direction A lies.

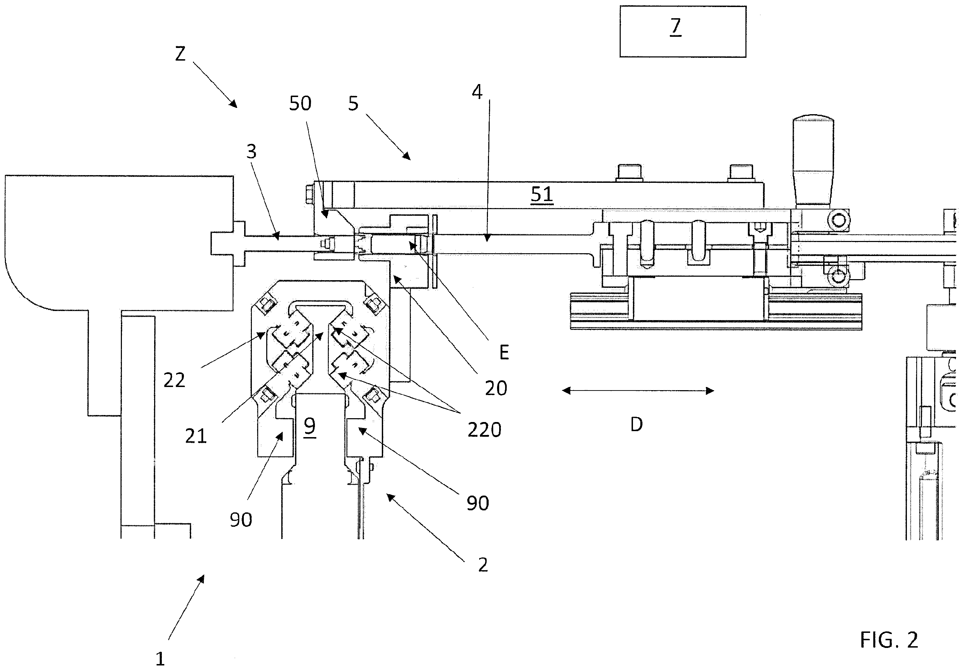

The check station 1 also comprises: a power supply assembly (not illustrated), which supplies the contact of the head 3 of the control assembly 3, 4, 5 with electrical power; and a measuring assembly 8 (illustrated only schematically and indicatively in Figures 1 and 2) connected to the control assembly 3, 4, 5, which measures a quantity of electrical energy representative of the electric resistance and/or the inductance of the electric circuit C (as will be better described below).

Advantageously, the proposed solution allows extreme precision of the checking operations. In fact, the perfect alignment between the head 3 and the cartridge E (or rather, of the relative axes T, L) in the checking area Z ensures optimal control.

Furthermore, again with reference to the figures, the precision of the control operations is ensured by the fact that the operations occur with the electric circuit C stationary in the checking area Z.

In general, several heads 3 may be provided at the checking area Z, to allow simultaneous checking of several cartridges E (the movement means 4, 5 are consequently provided for this purpose).

The quantity of electrical energy measured by the measuring assembly 7 can be a voltage (at a predetermined current), or a current (at a predetermined voltage), or a combination of voltage and current (when neither are predetermined), or a frequency of a voltage and/or a current (in the case of alternating current), or a phase shift between voltage and current (in the case of alternating current), or a time constant of voltage or current (in the case of direct current). In this way, when the electrical quantity is measured, the electrical resistance/inductance (or a representative value of these parameters) of the circuit (in particular of the heating element) can be determined thanks to the measuring assembly 7, which is able to convert it to that effect.

According to the preferred embodiment illustrated, the movement direction D is perpendicular to the advancement direction (see in detail Figure 1). In this case, clearly, the axes T, L of the head 3 and of the cartridge E, respectively, are also perpendicular to the advancement direction A. This specification guarantees even more precision to the checking operations. According to a preferred embodiment, the electric circuit C of the cartridge E is moved to be brought into contact with the electrical contact 30, which remains stationary (or rather, only the cartridge E is moved). Advantageously, this preferred embodiment ensures that the electrical contact 30, remaining stationary for testing several cartridges E, is not damaged over time, or in any case, is damaged less than in the case in which it is moved towards the cartridges E. In fact, the electrical contact 30 is particularly delicate and susceptible to damage over time, and therefore the relative movement of the checking measurements could cause it damage.

In accordance with the attached figures, the movement means 4, 5 comprise at least one first pushing element 4 that pushes a cartridge E, which is in the checking area Z, retained by a holding element 20, along the moving direction D, from a first position F1 to a second position F2. When it is in the second position F2, the electric circuit C of the cartridge E contacts the electrical contact 30 of the head 3.

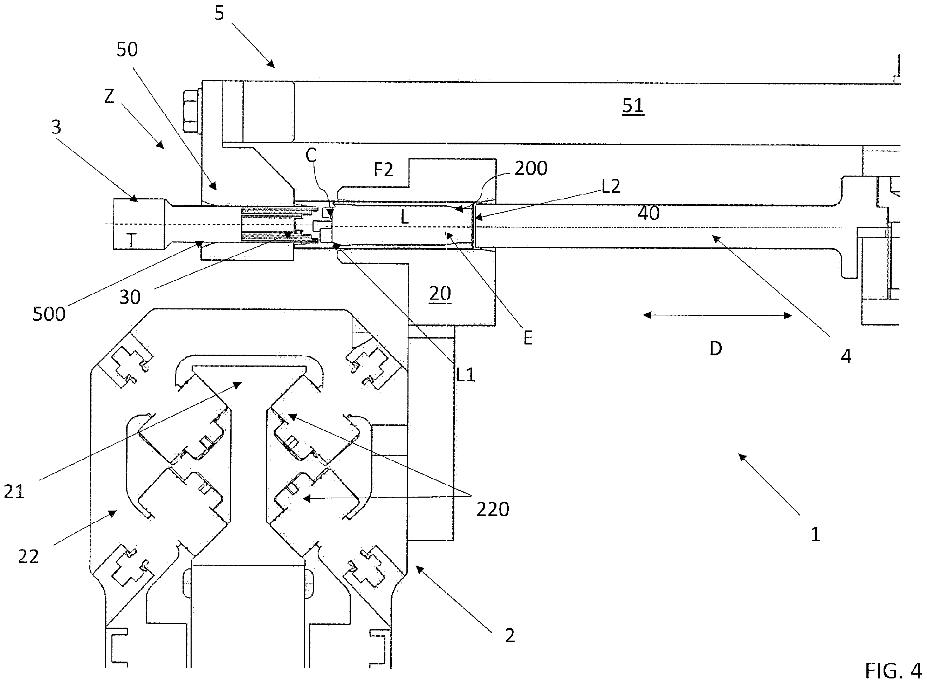

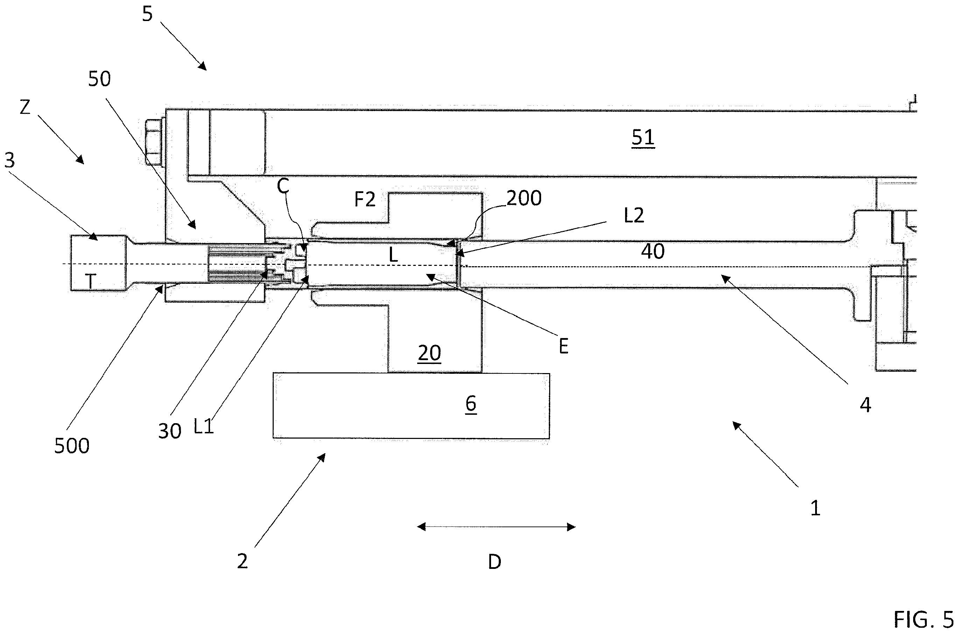

With particular reference to Figure 3, the cartridge E is in the first position F1 retained by a holding element 20. With reference, instead, to Figures 4 and 5, the cartridge E is in the second position F2, again retained by the holding element 20, following the action of the first pushing element 4.

With reference to the attached figures, the holding elements 20 comprise a plurality of supports 20, each provided with a through-seat 200 to receive a corresponding cartridge E with a horizontal arrangement (particular reference is made to Figures 3-5). Moreover, the first pushing element 4 is shaped to enter the seat 200 of a support when it is in the checking area Z, contacting the second end L2 of the cartridge E, to push it from the first position F1 to the second position F2 along the movement D direction in a first pushing direction. The first pushing element 4 has a mainly longitudinal development with the relative axis 40 arranged parallel to the axis L, T of the cartridge E and the head 3.

The holding elements 20 may also be different from those illustrated and may include, for example, gripping means (e.g. clamps) or different support members provided with suitable housings. Preferably, the holding elements 20 retain or, in any case, support the cartridges E at a relative side wall.

Still with reference to what is illustrated, the movement means 4, 5 comprise a second pushing element 5 that pushes the cartridge E from the second position F2 to the first position F1 (in the movement direction D, in a second pushing direction that is opposite to the first pushing direction indicated above) following contact with the electrical contact 30 of the head 3.

In detail, the second pushing element 5 contacts the first end L1 of the cartridge E to push it from the second position F2 to the first position F1. In particular, when the cartridge E is pushed by the first pushing element 4 into the second position F2, the relative electric circuit C contacts the electrical contact 30 of the head 3, and one edge of the cartridge E abuts the second pushing element 5.

Still with reference to the attached figures, the second pushing element 5 comprises a through-seat 500 (indicated in Figures 3-5), which receives the head 3 therein. In particular, the second pushing element 5 comprises an enlarged portion 50 provided with the through-seat 500. In detail, the second pushing element 5 comprises the through-seat 500 of the second pushing element 5 partially housing the head 3 therein: as can be seen from the figures, the relative electrical contact 30 projects from the seat 500 towards the first end L1 of the cartridge E.

Preferably, the through-seat 500 of the second pushing element 5 forms an opening with smaller dimensions than the first end L1 of the cartridge E. As already mentioned above, in fact, while the electric circuit C of the cartridge E contacts the electrical contact 30 of the head 3, an edge of the first end L1 of the cartridge E contacts the second pushing element 5, or rather, it remains outside the through-seat 500.

Still with reference to the attached figures, the second pushing element 5 also comprises a support portion 51 connected to the enlarged portion 50. In particular, the support portion 51 has a prevalent development that is parallel to the movement direction D and carries the enlarged portion 50 in an overhanging manner.

According to an alternative that is not illustrated, the first pushing element and the second pushing element coincide, or rather, they are formed by a single element.

According to the preferred embodiment of the invention, the movement means 4, 5 comprise an actuator (not visible in the attached figures) which drives the first pushing element 4 and the second pushing element 5 to move the cartridge E from the first position F1 to the second position F2 and vice versa. Advantageously, this specification is particularly practical.

According to a variant, the movement means 4, 5 comprise two independent actuators for moving the first pushing element 4 and the second pushing element 5, respectively.

According to the preferred embodiment described above, the cartridge E is moved between the first position F1 and the second position F2, while the head 3 remains stationary, that is, in a fixed position with respect to the cartridge E and the holding elements 20.

According to an alternative embodiment that is not illustrated, the head 3 is movable along the movement direction D from an inoperative position in which it is not in contact with the electric circuit C of a cartridge E, to an operative position in which it contacts the circuit electric C, and vice versa. In this case, therefore, the cartridge E is kept stationary in the checking area Z, while the head 3 moves as described above.

According to another embodiment, also not illustrated, both the head 3 and the cartridge E are moved along the movement direction D in reciprocal approach and in reciprocal distancing.

According to the preferred embodiment, the conveying device 2 comprises a plurality of movable units 22, each arranged to receive at least one electronic cigarette cartridge E. In particular, the movable units 22 can be moved along the advancement path P independently from each other. Advantageously, this specification allows the station 1 to be managed in a particularly flexible manner, since the movement of a single cartridge E does not depend on the movement of the other cartridges E. Each movable unit 22 can also receive more than one cartridge E.

An application of the embodiment described above is illustrated in Figures 1-4, in which the conveying device 2 also comprises: a guide 21 arranged along the advancement path P, with the aforementioned movable units 22 (visible in Figure 1) which are slidable along the guide 21 and that carry the holding elements 20 (for example, overhanging as in Figures 1-4). Moreover, the conveying device 2 comprises: a linear electric motor 9 (visible only in an indicative manner in Figure 2) bound to the guide 21 and comprising a plurality of coils (individually energizable); and a plurality of magnets 90 (these are also only shown in Figure 2) bound to the movable units 22 for interacting with the coils of the electric linear motor 9, allowing movement of the movable units 22 along the guide 21 independently from each other. In other words, according to this embodiment, the conveying device 2 is a linear motor conveyor. The electromagnetic field generated by the coils of the linear electric motor 9 interacts with the magnets 90 attached to the movable units 22 to control their movement along the guide 21.

For example, the guide 21 forms a closed-loop profile (detail not visible in the attached figures). As a consequence, the linear electric motor 9 also develops according to a closed-loop profile and can be internally bound to the closed loop defined by the guide 21.

The movable units 22 are preferably carriages, or rather, are provided with wheels 220 (shown in Figures 2-4) for sliding along the guide 21. Preferably, the carriages 22 have an inverted U-shaped profile, and the magnets 90 are carried inside the inverted U-shaped profile of the carriages 22.

Advantageously, the check station 1 in accordance with this embodiment is particularly efficient thanks to the movement of the carriages by means of the linear motor system.

In general, the movable units 22 (in particular the carriages) can also be moved in groups of two or more, depending on the configuration of the station 1. For example, there may be two heads 3 (as partially visible in Figure 1) in the control assembly 3, 4, 5, and two electric circuits of two separate cartridges E can be controlled simultaneously.

According to a different embodiment, shown in Figure 5, the conveying device 2 comprises a belt 6 which carries the holding elements 20 (for example, bound in an overhanging manner with respect to the belt 6).

The belt 6 generally means any flat conveyor (for example, a tape), for example, a closed-loop belt (shown only partially in Figure 5).

Clearly, the conveying device 2 can also be different from the examples described and illustrated here.

Preferably the measuring assembly 7 comprises a central control unit 7 (illustrated only in a schematic manner in Figures 1 and 2) configured to compare the measured quantity of electrical energy with at least one reference value, and to generate a reject signal if the measured quantity of electrical energy is different from the at least one reference value. The reference value can clearly be a range of values.

For example, the check station 1 can further comprise a reject assembly (not illustrated), arranged downstream of the control assembly 3, 4, 5 along the advancement path P, and arranged to remove the cartridges E for which a reject signal has been generated from the advancement path P. For example, the reject assembly may comprise a pusher which, in the event that a reject signal is generated for a cartridge E, pushes the cartridge E in a reject direction parallel to the aforesaid movement direction D, disengaging it from the holding elements 20. The reject assembly may comprise a collection container arranged to receive the cartridges E that have been discarded, or rather, which have been taken out of the advancement path P. Advantageously, in this way, the cartridges E that do not meet certain functional requirements are released from the advancement path P in a simple and quick way.

The control assembly 3, 4 and 5 may also comprise at least one first optical device 8 (visible in Figure 1) arranged upstream of the control assembly 3, 4, 5 along the advancement path P, for detecting an image of the electric circuit C of the cartridges E to be checked. The first optical device 8 is, for example, a camera.

In particular, the first optical device 8 can detect any defects already present before the checking operation, or rather, any defects present on the parts that are fed upstream.

The control assembly 3, 4, 5 may also comprise at least one second optical device (not illustrated), arranged downstream of the control assembly 3, 4, 5 along the advancement path P, for detecting an image of the electric circuit C of the checked cartridges E. The second optical device is, for example, a camera. The second optical device can be provided instead of or in addition to the first optical device 8. In particular, if the second optical device is provided in addition to the first optical device, the second optical device 8 can detect any defects present both before and after the checking operation. In this way, by comparing the detected images, it is possible to establish whether the defects were caused during the checking operation itself.

In this way, with the first 8 and/or second optical device, it is also possible to visually check the state of the electric circuit C, in particular of the terminals (contacts), to possibly allow an association between detected malfunction and image (e.g. geometric defect detected).

The invention also relates to a method for checking the electric circuit C of cartridges E of electronic cigarettes, for example, which can be implemented by means of a check station 1 described above. As already mentioned above, each cartridge E has a longitudinal axis L with a first end L1 and a second end L2, and the electric circuit C of each cartridge E (refer to the above) is arranged at the first end L1 of the relative longitudinal axis L.

The method includes the steps of:
- arranging a head 3 having a longitudinal axis T and comprising at least one electrical contact 30 (preferably two) positioning it with a horizontal arrangement along the cartridge advancement path P, at a checking area Z;
- conveying the cartridges E of electronic cigarettes along an advancement direction A in a horizontal arrangement up to the checking area Z;
- supplying the electrical contact 30 of the head 3 with electrical energy;
- bringing the electric circuit C into contact with the electrical contact of the head 3;
- measuring a quantity of electrical energy representative of an electric resistance and/or inductance of the checked electric circuit C.

As already mentioned above, the horizontal arrangement of the cartridges E and of the head 3 means that these are arranged with the relative longitudinal axis L lying on a plane parallel to the plane on which the advancement direction A of the cartridges E lies (or rather, on a plane parallel to that on which the advancement path P lies).

Advantageously, the method described above allows checking of the electric circuits in a particularly precise and effective manner.

Preferably, the cartridges E are stopped when they reach the checking area Z.

Preferably, the step of bringing the electric circuit C into contact with the electrical contact 30 of the head comprises the sub-step of moving the cartridge E toward the head 3 (as in the illustrated case), while the head 3 remains stationary. This aspect, as already discussed previously for the station 1, avoids damage over time of the electrical contact 30, which could become damaged by the continuous movement for performing the checking operations.

Regarding the details of the movement of the cartridge E, this can take place, for example, as described previously.

According to an alternative not illustrated, the step of bringing the electric circuit C and the electrical contact 30 into contact with each other comprises the step of moving the head 3 towards the cartridge E.

According to another alternative not illustrated, the step of bringing the electric circuit C and the electrical contact 30 into contact with each other comprises the step of moving the head 3 towards the cartridge E and the cartridge E towards the head 3.

According to the preferred embodiment, the step of conveying the cartridges E of electronic cigarettes along an advancement direction A comprises the sub-step of conveying the cartridges E independently from each other. Advantageously, this aspect guarantees maximum flexibility for checking operations.

Preferably, the step of measuring a quantity of electrical energy representative of an electric resistance and/or inductance of the checked electric circuit C comprises the sub-steps of:
- comparing the measured quantity of electrical energy with at least one reference value (or a range of values); and
- emitting a reject signal if the measured quantity of electrical energy is different from the at least one reference value.

In this way it is possible to identify any malfunctions and discard non-compliant products.

Regarding measuring the quantity of electrical energy representative of the electrical resistance and/or of the inductance of the checked electric circuit C, reference should be made to what has been said for the check station 1 described above.

This method can be implemented, for example, with the check station 1 described above.

The present invention also relates to an assembling machine (only partially visible in Figure 1) for cartridges E of electronic cigarettes comprising a plurality of assembling stations arranged along an assembling path and at least one first station 1 for checking the electric circuit C, and which is arranged upstream and/or downstream of the assembling stations and/or interposed between the assembling stations. The check station 1 can be compliant with any of the described embodiments.

The present invention also relates to a filling machine for electronic cigarettes (not illustrated) comprising at least one filling station 1 for filling electronic cigarettes with a product to be vaporized; and at least one first station 1 for checking the electric circuit C of electronic cigarettes, preferably arranged upstream of the filling station 1. The filling station 1 comprises, for example, a plurality of nozzles that dispense the product inside the cartridges E.

The assembling machine M and the filling machine described above each integrate the checking function of the electric circuit C of the electronic cigarettes.

The assembling machine M and the filling machine can also be connected to each other to form a single system.

## Claims

1. A station (1) for checking the electric circuit (C) of cartridges (E) of electronic cigarettes, the cartridges (E) having a longitudinal axis (L) with a first end (L1) and a second end (L2); the electronic circuit (C) of each cartridge (E) being arranged at the first end (L1) of its longitudinal axis (L);
the station (1) comprising:
a conveying device (2) for conveying the cartridges (E) of electronic cigarettes along an advancement direction (A); the conveying device (2) comprises a plurality of holding elements (20) for retaining the cartridges (E) in a horizontal arrangement during their conveying; and
a control assembly (3, 4, 5) arranged along the advancement path (P) of the cartridges at a checking area (Z), and in turn comprising:
- a head (3) provided with at least one electrical contact (30); the head (3) having a longitudinal axis (T) and positioned with a horizontal arrangement along the advancement path (P); the head (3) and the conveying device (2) being reciprocally arranged in such a way that the electrical contact (30) and the electric circuit (C) are facing and aligned with each other when a cartridge (E) is conveyed into the checking area (Z);
- movement means (4, 5) arranged for bringing the electric circuit (C) of the cartridge (E) into contact with the electrical contact (30) of the head (3) when the cartridge (E) is conveyed into the checking area (Z);
a power supply assembly, which supplies the contact of the head (3) of the control assembly (3, 4, 5) with electrical energy; and
a measuring assembly (7), connected to the control assembly (3), which measures at least one quantity of electrical energy representative of the electric resistance and/or inductance of the electric circuit (C);
**characterized in that**:
the conveying device (2) comprises a plurality of movable units (22), each arranged to receive at least one cartridge (E); the movable units (22) can be moved along the advancement path (P) independently from each other.

2. The station (1) according to the preceding claim, wherein the electric circuit (C) of the cartridge (E) and the electrical contact (30) of the head are brought into contact along a movement direction (D) which is perpendicular with respect to the advancement direction (A).

3. The station (1) according to claims 1 or 2, wherein the electric circuit (C) of the cartridge (E) is moved to be brought into contact with the electrical contact (30), which remains stationary.

4. The station (1) according to any of the preceding claims, wherein the movement means (4, 5) comprise at least one first pushing element (4) which pushes a cartridge (E) that is in the checking area (Z), retained by a holding element (20), along the movement direction (D) from a first position (F1) to a second position (F2); in said second position (F2) the cartridge (E) comes into contact with the electrical contact (30) of the head (3).

5. The station (1) according to the preceding claim, wherein the holding elements (20) comprise a plurality of supports (20) each provided with a through-seat (200) for receiving a corresponding cartridge (E) in a horizontal arrangement; the first pushing element (4) being shaped for entering into the seat (200) of a support (20) when it is in the checking area, (Z) contacting the second end (L2) of the cartridge (E), in order to push it from the first position (F1) to the second position (F2) along the movement direction (D).

6. The station (1) according to claims 4 or 5, wherein the movement means (4, 5) comprise at least one second pushing element (5) that pushes the cartridge (E) from the second position (F2) to the first position (F1) after the cartridge (E) has contacted the electrical contact (30) of the head (3).

7. The station (1) according to the preceding claim, wherein the second pushing element (5) contacts the first end (L1) of the cartridge (E) in order to push it from the second position (F2) to the first position (F1).

8. The station (1) according to claim 6 or 7, wherein the second pushing element (5) comprises a through-seat (500) that receives the head (3).

9. The station (1) of the preceding claim, wherein the through-seat (500) of the second pushing element (5) defines an opening that has smaller dimensions with respect to the first end (L1) of the cartridge (E).

10. The station (1) according to any of the claims from 6 to 9, wherein the movement means (4, 5) comprise an actuator that activates the first pushing element (4) and the second pushing element (5) for moving the cartridge (E) from the first position (F1) to the second position (F2), and vice versa.

11. The station (1) according to any of the preceding claims, wherein the head (3) is movable along the movement direction (D) from an inoperative position where it is not in contact with the electric circuit (C) of a cartridge (E), to an operative position where it is in contact with the electric circuit (C), and vice versa.

12. The station (1) according to any of the preceding claims, wherein the conveying device (2) further comprises: a guide (21) positioned along the advancement path (P); wherein the plurality of movable units (22) can slide along the guide (21) and which carry the holding elements (20); and a linear electric motor (9) bound to the guide (21) and comprising a plurality of coils; a plurality of magnets (90) bound to the movable units (22) for interacting with the coils of the linear electric motor (9) allowing the movable units (22) to move independently along the guide (21).

13. An assembling machine (M) for cartridges (E) of electronic cigarettes comprising a plurality of assembling stations arranged along an assembling path, and at least one first station (1) for checking the electric circuit (C) of cartridges (E) of electronic cigarettes according to any of the preceding claims; the first check station (1) being arranged upstream and/or downstream of the assembling stations and/or interposed between the assembling stations.

14. A method for checking the electric circuit (C) of cartridges (E) of electronic cigarettes, each cartridge (E) having a longitudinal axis (L) with a first end (L1) and a second end (L2); the electronic circuit (C) of each cartridge (E) being arranged at the first end (L1) of its longitudinal axis (L); the method comprising the steps of:
- providing a head (3) having a longitudinal axis (T) and comprising at least one electrical contact (30), positioning it with a horizontal arrangement along the cartridge advancement path (P), at a checking area (Z);
- conveying the cartridges (E) of electronic cigarettes along an advancement direction (A) in a horizontal arrangement up to the checking area (Z);
- supplying the electrical contact (30) of the head (3) with electrical energy;
- bringing the electric circuit (C) into contact with the electrical contact of the head (3);
- measuring a quantity of electrical energy representative of an electric resistance and/or inductance of the checked electric circuit (C);
**characterized in that**:
the step of conveying the cartridges (E) of electronic cigarettes along an advancement direction (A) comprises the sub-step of conveying the cartridges (E) independently from each other.

15. The method according to the preceding claim, wherein the step of bringing the electric circuit (C) into contact with the electrical contact (30) of the head comprises the step of moving the cartridge (E) towards the head (3), while the head (3) remains still.

16. The method according to claims 14 or 15, wherein the step of bringing the electric circuit (C) into contact with the electrical contact (30) of the head comprises the step of moving the head (3) toward the cartridge (E).

## Patentansprüche

1. Station (1) zum Prüfen der elektrischen Schaltung (C) von Patronen (E) elektronischer Zigaretten, wobei die Patronen (E) eine Längsachse (L) mit einem ersten Ende (L1) und einem zweiten Ende (L2) aufweisen;
wobei die elektronische Schaltung (C) jeder Patrone (E) am ersten Ende (L1) ihrer Längsachse (L) angeordnet ist;
wobei die Station (1) Folgendes umfasst:
eine Fördervorrichtung (2) zum Fördern der Patronen (E) von elektronischen Zigaretten entlang einer Vorschubrichtung (A);
wobei die Fördervorrichtung (2) eine Vielzahl von Halteelementen (20) umfasst, um die Patronen (E) während ihres Transports in einer horizontalen Anordnung zu halten; und
wobei eine Steueranordnung (3, 4, 5), die entlang des Vorschubweges (P) der Patronen in einem Prüfbereich (Z) angeordnet ist und ihrerseits Folgendes umfasst:
- einen Kopf (3), der mit mindestens einem elektrischen Kontakt (30) versehen ist;
wobei der Kopf (3) eine Längsachse (T) hat und in horizontaler Anordnung entlang des Vorschubweges (P) angeordnet ist;
wobei der Kopf (3) und die Fördervorrichtung (2) so zueinander angeordnet sind, dass der elektrische Kontakt (30) und die elektrische Schaltung (C) einander zugewandt und ausgerichtet sind, wenn eine Patrone (E) in den Prüfbereich (Z) befördert wird;
- Bewegungsmittel (4, 5), die so angeordnet sind, dass sie die elektrische Schaltung (C) der Patrone (E) mit dem elektrischen Kontakt (30) des Kopfes (3) in Kontakt bringen, wenn die Patrone (E) in den Prüfbereich (Z) befördert wird;
eine Stromversorgungseinheit, die den Kontakt des Kopfes (3) der Steueranordnung (3, 4, 5) mit elektrischer Energie versorgt; und
eine Messanordnung (7), die mit der Steueranordnung (3) verbunden ist und mindestens eine Größe der elektrischen Energie misst, die für den elektrischen Widerstand und/oder die Induktivität der elektrischen Schaltung (C) repräsentativ ist;
**dadurch gekennzeichnet, dass**:
die Fördervorrichtung (2) eine Vielzahl von beweglichen Einheiten (22) umfasst, die jeweils so angeordnet sind, dass sie mindestens eine Patrone (E) aufnehmen können;
die beweglichen Einheiten (22) unabhängig voneinander entlang des Vorschubweges (P) bewegt werden können.

2. Station (1) nach dem vorhergehenden Anspruch,
wobei die elektrische Schaltung (C) der Patrone (E) und der elektrische Kontakt (30) des Kopfes entlang einer Bewegungsrichtung (D), die senkrecht zur Vorschubrichtung (A) ist, in Kontakt gebracht werden.

3. Station (1) nach Anspruch 1 oder 2,
wobei die elektrische Schaltung (C) der Patrone (E) bewegt wird, um in Kontakt mit dem elektrischen Kontakt (30) gebracht zu werden, der stationär bleibt.

4. Station (1) nach einem der vorhergehenden Ansprüche,
wobei die Bewegungsmittel (4, 5) mindestens ein erstes Schiebeelement (4) umfassen, das eine Patrone (E), die sich im Prüfbereich (Z) befindet und von einem Halteelement (20) gehalten wird, entlang der Bewegungsrichtung (D) von einer ersten Position (F1) in eine zweite Position (F2) schiebt;
wobei die Patrone (E) in der zweiten Position (F2) mit dem elektrischen Kontakt (30) des Kopfes (3) in Berührung kommt.

5. Station (1) nach dem vorhergehenden Anspruch,
wobei die Halteelemente (20) eine Vielzahl von Trägern (20) umfassen, die jeweils mit einem Durchgangssitz (200) zur Aufnahme einer entsprechenden Patrone (E) in horizontaler Anordnung versehen sind;
wobei das erste Schiebeelement (4) so geformt ist, dass es in den Sitz (200) eines Trägers (20) eindringt, wenn es sich in der Prüfzone (Z) befindet, und das zweite Ende (L2) der Patrone (E) berührt, um sie aus der ersten Position (F1) in die zweite Position (F2) entlang der Bewegungsrichtung (D) zu schieben.

6. Station (1) nach Anspruch 4 oder 5,
wobei die Bewegungsmittel (4, 5) mindestens ein zweites Schiebeelement (5) umfassen, das die Patrone (E) von der zweiten Position (F2) in die erste Position (F1) schiebt, nachdem die Patrone (E) den elektrischen Kontakt (30) des Kopfes (3) kontaktiert hat.

7. Station (1) nach dem vorhergehenden Anspruch,
wobei das zweite Schiebeelement (5) das erste Ende (L1) der Patrone (E) berührt, um sie von der zweiten Position (F2) in die erste Position (F1) zu schieben.

8. Station (1) nach Anspruch 6 oder 7,
wobei das zweite Schiebeelement (5) einen Durchgangssitz (500) aufweist, der den Kopf (3) aufnimmt.

9. Station (1) nach dem vorhergehenden Anspruch,
wobei der Durchgangssitz (500) des zweiten Schiebeelements (5) eine Öffnung definiert, die kleinere Abmessungen in Bezug auf das erste Ende (L1) der Patrone (E) aufweist.

10. Station (1) nach einem der Ansprüche 6 bis 9,
wobei die Bewegungsmittel (4, 5) einen Aktuator umfassen, der das erste Schiebeelement (4) und das zweite Schiebeelement (5) aktiviert, um die Patrone (E) von der ersten Position (F1) in die zweite Position (F2) und umgekehrt zu bewegen.

11. Station (1) nach einem der vorhergehenden Ansprüche,
wobei der Kopf (3) entlang der Bewegungsrichtung (D) von einer Ruheposition, in der er nicht in Kontakt mit der elektrischen Schaltung (C) einer Patrone (E) ist, in eine Betriebsposition, in der er in Kontakt mit der elektrischen Schaltung (C) ist, und umgekehrt, bewegbar ist.

12. Station (1) nach einem der vorhergehenden Ansprüche,
wobei die Fördervorrichtung (2) ferner Folgendes umfasst:
eine Führung (21), die entlang des Vorschubweges (P) angeordnet ist;
wobei die Vielzahl der beweglichen Einheiten (22) entlang der Führung (21) gleiten kann und die Halteelemente (20) trägt; und
einen elektrischen Linearmotor (9), der mit der Führung (21) verbunden ist und eine Vielzahl von Spulen umfasst;
eine Vielzahl von Magneten (90), die mit den beweglichen Einheiten (22) verbunden sind, um mit den Spulen des elektrischen Linearmotors (9) zusammenzuwirken, so dass sich die beweglichen Einheiten (22) unabhängig entlang der Führung (21) bewegen können.

13. Montagemaschine (M) für Patronen (E) von elektronischen Zigaretten mit einer Vielzahl von entlang einer Montagestrecke angeordneten Montagestationen und mindestens einer ersten Station (1) zur Überprüfung der elektrischen Schaltung (C) von Patronen (E) elektronischer Zigaretten nach einem der vorhergehenden Ansprüche;
wobei die erste Prüfstation (1) den Montagestationen vor- und/oder nachgeschaltet und/oder zwischen den Montagestationen angeordnet ist.

14. Verfahren zum Prüfen der elektrischen Schaltung (C) von Patronen (E) elektronischer Zigaretten, wobei jede Patrone (E) eine Längsachse (L) mit einem ersten Ende (L1) und einem zweiten Ende (L2) aufweist;
wobei die elektronische Schaltung (C) jeder Patrone (E) am ersten Ende (L1) ihrer Längsachse (L) angeordnet ist; wobei das Verfahren die folgenden Schritte umfasst:
- Bereitstellen eines Kopfes (3) mit einer Längsachse (T) und mit mindestens einem elektrischen Kontakt (30), Positionieren desselben in einer horizontalen Anordnung entlang des Patronenvorschubweges (P) in einem Prüfbereich (Z);
- Befördern der Patronen (E) elektronischer Zigaretten entlang einer Vorschubrichtung (A) in horizontaler Anordnung bis zum Prüfbereich (Z);
- Versorgen des elektrischen Kontakts (30) des Kopfes (3) mit elektrischer Energie;
- In-Kontakt-Bringen der elektrischen Schaltung (C) mit dem elektrischen Kontakt des Kopfes (3);
- Messen einer elektrischen Energiemenge, die für einen elektrischen Widerstand und/oder eine Induktivität der geprüften elektrischen Schaltung (C) repräsentativ ist;
**dadurch gekennzeichnet, dass**:
der Schritt des Förderns der Patronen (E) von elektronischen Zigaretten entlang einer Vorschubrichtung (A) den Teilschritt des Förderns der Patronen (E) unabhängig voneinander umfasst.

15. Verfahren nach dem vorhergehenden Anspruch,
wobei der Schritt des In-Kontakt-Bringens der elektrischen Schaltung (C) mit dem elektrischen Kontakt (30) des Kopfes den Schritt des Bewegens der Patrone (E) in Richtung des Kopfes (3) umfasst, während der Kopf (3) stillsteht.

16. Verfahren nach einem der Ansprüche 14 oder 15,
wobei der Schritt des In-Kontakt-Bringens der elektrischen Schaltung (C) mit dem elektrischen Kontakt (30) des Kopfes den Schritt des Bewegens des Kopfes (3) in Richtung der Patrone (E) umfasst.

## Revendications

1. Station (1) pour la vérification du circuit électrique (C) de cartouches (E) de cigarettes électroniques, les cartouches (E) ayant un axe longitudinal (L) avec une première extrémité (L1) et une deuxième extrémité (L2) ; le circuit électronique (C) de chaque cartouche (E) étant agencé au niveau de la première extrémité (L1) de son axe longitudinal (L) ;
la station (1) comprenant :
un dispositif d'acheminement (2) pour acheminer les cartouches (E) de cigarettes électroniques le long d'une direction d'avancement (A) ; le dispositif d'acheminement (2) comprend une pluralité d'éléments de maintien (20) pour retenir les cartouches (E) selon un agencement horizontal lors de leur acheminement ; et
un ensemble de commande (3, 4, 5) agencé le long du chemin d'avancement (P) des cartouches au niveau d'une zone de contrôle (Z), et comprenant successivement :
- une tête (3) pourvue d'au moins un contact électrique (30) ; la tête (3) ayant un axe longitudinal (T) et étant positionnée avec un agencement horizontal le long du chemin d'avancement (P) ; la tête (3) et le dispositif d'acheminement (2) étant mutuellement agencés de façon que le contact électrique (30) et le circuit électrique (C) sont en face et alignés l'un avec l'autre lorsqu'une cartouche (E) est acheminée dans la zone de contrôle (Z) ;
- des moyens de mouvement (4, 5) agencés de façon à amener le circuit électrique (C) de la cartouche (E) en contact avec le contact électrique (30) de la tête (3) lorsque la cartouche (E) est acheminée dans la zone de contrôle (Z) ;
un ensemble d'alimentation, qui alimente le contact de la tête (3) de l'ensemble de commande (3, 4, 5) en énergie électrique ; et
un ensemble de mesure (7), connecté à l'ensemble de commande (3), qui mesure au moins une quantité d'énergie électrique représentative de la résistance électrique et/ou de l'inductance du circuit électrique (C) ; **caractérisée en ce que** :
le dispositif d'acheminement (2) comprend une pluralité d'unités mobiles (22), chacune conçue de façon à recevoir au moins une cartouche (E) ; les unités mobiles (22) peuvent être déplacées le long du chemin d'avancement (P) indépendamment les unes des autres.

2. Station (1) selon la revendication précédente, dans laquelle le circuit électrique (C) de la cartouche (E) et le contact électrique (30) de la tête sont mis en contact selon une direction de déplacement (D) qui est perpendiculaire par rapport à la direction d'avancement (A) .

3. Station (1) selon les revendications 1 ou 2, dans laquelle le circuit électrique (C) de la cartouche (E) est déplacée de façon à être mise en contact avec le contact électrique (30), qui reste stationnaire.

4. Station (1) selon l'une quelconque des revendications précédentes, dans laquelle les moyens de mouvement (4, 5) comprennent au moins un premier élément de poussée (4) qui pousse une cartouche (E) qui se trouve dans la zone de contrôle (Z), retenue par un élément de maintien (20), selon la direction de déplacement (D) depuis une première position (F1) jusqu'à une deuxième position (F2) ; dans ladite deuxième position (F2), la cartouche (E) vient en contact avec le contact électrique (30) de la tête (3).

5. Station (1) selon la revendication précédente, dans laquelle les éléments de maintien (20) comprennent une pluralité de supports (20) munis chacun d'un siège traversant (200) pour recevoir une cartouche correspondante (E) dans un agencement horizontal ; le premier élément de poussée (4) étant conformé pour entrer dans le siège (200) d'un support (20) lorsqu'il se trouve dans la zone de contrôle (Z) en contact avec la deuxième extrémité (L2) de la cartouche (E), afin de la pousser de la première position (F1) jusqu'à la deuxième position (F2) selon la direction de déplacement (D).

6. Station (1) selon les revendications 4 ou 5, dans laquelle les moyens de mouvement (4, 5) comprennent au moins un deuxième élément de poussée (5) qui pousse la cartouche (E) depuis la deuxième position (F2) jusqu'à la première position (F1) après que la cartouche (E) a contacté le contact électrique (30) de la tête (3).

7. Station (1) selon la revendication précédente, dans laquelle le deuxième élément de poussée (5) vient en contact avec la première extrémité (L1) de la cartouche (E) afin de la pousser depuis la deuxième position (F2) jusqu'à la première position (F1).

8. Station (1) selon la revendication 6 ou la revendication 7, dans laquelle le deuxième élément de poussée (5) comprend un siège traversant (500) qui reçoit la tête (3).

9. Station (1) selon la revendication précédente, dans laquelle le siège traversant (500) du deuxième élément de poussée (5) définit une ouverture qui a des plus petites dimensions par rapport à la première extrémité (L1) de la cartouche (E).

10. Station (1) selon l'une des revendications 6 à 9, dans laquelle les moyens de mouvement (4, 5) comprennent un actionneur qui active le premier élément de poussée (4) et le deuxième élément de poussée (5) pour déplacer la cartouche (E) depuis la première position (F1) jusqu'à la deuxième position (F2), et inversement.

11. Station (1) selon l'une quelconque des revendications précédentes, dans lequel la tête (3) est mobile le long de la direction de déplacement (D) depuis une position inopérante dans laquelle elle n'est pas en contact avec le circuit électrique (C) d'une cartouche (E), jusqu'à une position opérante dans laquelle elle est en contact avec le circuit électrique (C), et inversement.

12. Station (1) selon l'une des revendications précédentes, dans laquelle le dispositif d'acheminement (2) comprend en outre : un guide (21) positionné le long du chemin d'avancement (P) ; les unités mobiles de la pluralité d'unités mobiles (22) sont aptes à coulisser le long du guide (21) et qui portent les éléments de maintien (20) ; et un moteur électrique linéaire (9) lié au guide (21) et comprenant une pluralité de bobines ; une pluralité d'aimants (90) liés aux unités mobiles (22) pour interagir avec les bobines du moteur électrique linéaire (9) permettant aux unités mobiles (22) de se déplacer indépendamment le long du guide (21).

13. Machine d'assemblage (M) de cartouches (E) de cigarettes électroniques comprenant une pluralité de stations d'assemblage agencées le long d'un chemin d'assemblage, et au moins une première station (1) pour contrôler le circuit électrique (C) des cartouches (E) de cigarettes électroniques selon l'une quelconque des revendications précédentes ; la première station de contrôle (1) étant agencée en amont et/ou en aval des stations d'assemblage et/ou étant interposée entre les stations d'assemblage.

14. Procédé de vérification du circuit électrique (C) de cartouches (E) de cigarettes électroniques, chaque cartouche (E) ayant un axe longitudinal (L) avec une première extrémité (L1) et une deuxième extrémité (L2) ; le circuit électronique (C) de chaque cartouche (E) étant agencé à la première extrémité (L1) de son axe longitudinal (L) ; le procédé comprenant les étapes suivantes :
- prévoir une tête (3) ayant un axe longitudinal (T) et comprenant au moins un contact électrique (30), la positionner avec un agencement horizontal le long du chemin d'avancement de la cartouche (P), au niveau d'une zone de contrôle (Z) ;
- acheminer les cartouches (E) de cigarettes électroniques le long d'une direction d'avancement (A) dans un agencement horizontal jusqu'à la zone de contrôle (Z) ;
- alimenter le contact électrique (30) de la tête (3) en énergie électrique ;
- mettre en contact le circuit électrique (C) avec le contact électrique de la tête (3) ;
- mesurer une quantité d'énergie électrique représentative d'une résistance électrique et/ou d'une inductance du circuit électrique contrôlé (C) ; **caractérisé en ce que** :
l'étape d'acheminement des cartouches (E) de cigarettes électroniques selon une direction d'avancement (A) comprend la sous-étape consistant à acheminer les cartouches (E) indépendamment les unes des autres.

15. Procédé selon la revendication précédente, dans lequel l'étape de mise en contact du circuit électrique (C) avec le contact électrique (30) de la tête comprend l'étape consistant à déplacer la cartouche (E) vers la tête (3), alors que la tête (3) reste immobile.

16. Procédé selon les revendications 14 ou 15, dans laquelle l'étape de mise en contact du circuit électrique (C) avec le contact électrique (30) de la tête comprend l'étape de déplacement de la tête (3) vers la cartouche (E) .
